# EUROPEAN PATENT APPLICATION

(11) **EP 4 694 185 A1**
(43) Date of publication of application: **11.02.2026**
(21) Application number: 24193407.4
(22) Date of filing: 07.08.2024
(51) Int. Cl.: H04R 1/08, B81B 7/00, H04R 19/00, H04R 19/04

(54) **ENVIRONMENTAL BARRIER STRUCTURE WITH INTEGRATED FLUID CHANNEL**

(71) Applicant: Infineon Technologies AG, 85579 Neubiberg (DE)
(72) Inventor: NEUMAIER, Daniel, 9560 Feldkirchen (AT); RIEDER, Bernhard, 93049 Regensburg (DE)
(74) Representative: Fischer, Florian

(57) **Abstract**

This disclosure concerns a MEMS pressure transducer package (100) comprising a substrate (110) having a through hole (120), and a MEMS pressure transducer device (130) covering the through hole (120) from a first substrate side (111). An environmental barrier structure (140) covers the through hole (120) from the first or an opposite second substrate side (111, 112). The environmental barrier structure (140) comprises a compliant membrane (150) being suspended inside a frame (160) and a fluid channel (170) extending through the frame (160), wherein the fluid channel (170) provides a fluid communication between a first and an opposite second side (151, 152) of the membrane (150).

## Description

### GENERAL DESCRIPTION

Embodiments of the present disclosure relate to a MEMS device (MEMS: Micro Electro Mechanical System) comprising an environmental barrier structure for providing environmental ingress protection. The innovative environmental barrier structure comprises an integrated fluid channel that serves to provide a separate vent path around the membrane.

### TECHNICAL BACKGROUND

A new generation of silicon MEMS microphone packages will have so-called environmental barriers implemented inside the package for protecting the delicate MEMS microphone system from water and dust ingress. In addition, the direct microphone implementation of nowadays environmental barriers will allow higher overall system performance and tighter tolerances when the microphone module is implemented in the targeted application system.

In MEMS microphone packages, environmental barriers have a plurality of mutual exclusive functions:
• Protect the microphone from dust particles
• Protect the microphone from water droplets and immersion
• Allow for a ventilation and hence a compensation of static pressures
• Acoustic sound transmission

As can be seen, the environmental barrier has to be rigid and dense / impermeable, on the one hand, in order to provide sufficient ingress protection even of smallest particles. On the other hand, the environmental barrier has to be permeable and flexible / compliant in order to provide sufficient ventilation and sound transmission. These functions are, however, mutually exclusive.

Currently, it is tried to solve the above mentioned trade-off by using thin and compliant ePTFE membranes. Due to its extruded, porous structure the membrane itself allows for deflection based sound transmission and ventilation. ePTFE has in addition also other very unique benefits like high temperature / solder stability. However, due to its rather complex structure it is not easy to design and optimize compliance and ventilation due to its interdependence. Moreover, due to upcoming restrictions on the usage of PFAS-based materials, ePTFE membranes will have to be replaced in the near future.

Thus, it is an object of the herein described innovative concept to enhance existing MEMS packages with respect to environmental ingress protection in order to overcome the above mentioned drawbacks and trade-offs.

This goal is achieved by means of the herein disclosed MEMS pressure transducer package having the features of the independent claims. The MEMS pressure transducer package comprises, inter alia, a substrate comprising a through hole, a MEMS pressure transducer device covering the through hole from a first substrate side, and an environmental barrier structure covering the through hole from the first or an opposite second substrate side. The innovative environmental barrier structure comprises at least a compliant membrane being suspended inside a frame, and a fluid channel being integrated in the frame and extending through the frame. The fluid channel provides a fluid communication between a first and an opposite second side of the membrane. According to the innovative approach, the membrane may be sufficiently flexible / compliant for providing good sound transmission, while the membrane may, at the same time, be sufficiently dense or even impermeable for providing excellent environmental ingress protection. The membrane itself does not need to be porous or permeable since ventilation may be provided by the fluid channel being integrated in the membrane's frame. Accordingly, the fluid channel may serve as a vent path.

Furthermore, since permeability may be a negligible feature of the membrane design, the membrane may be made from material other than ePTFE. Accordingly, the innovative approach allows for higher material selection flexibility for the membrane material thereby enhancing compliance and ventilation of an environmental barrier module. According to the innovative concept, the ventilation path is separated from the membrane. This can be achieved by implementing a specific ventilation path within the frame of the environmental barrier module. Thus, the membrane itself can be sealed to become impermeable and without the need of porous or extruded structures. In addition, this might also be helpful for the ingress protection performance. Furthermore, such an environmental barrier module can serve as a one to one replacement for current ePTFE based environmental barrier approaches, without the need of major changes in the package concept, or package production flow.

Further embodiments and advantageous aspects are recited in the dependent claims.

In the following, embodiments of the present disclosure are described in more detail with reference to the figures, in which
- Fig. 1: shows a schematic cross-sectional view of a MEMS pressure transducer package according to an embodiment,
- Fig. 2: shows a schematic cross-sectional view of an environmental barrier structure with integrated fluid channel according to an embodiment,
- Fig. 3: shows a schematic cross-sectional view of a MEMS pressure transducer package according to a further embodiment,
- Fig. 4: shows a schematic cross-sectional view of a MEMS pressure transducer package according to a further embodiment,
- Fig. 5: shows a schematic cross-sectional view of a MEMS pressure transducer package according to a further embodiment,
- Fig. 6: shows a schematic cross-sectional view of a MEMS pressure transducer package according to a further embodiment,
- Fig. 7: shows a schematic cross-sectional view of a MEMS pressure transducer package according to a further embodiment,
- Fig. 8: shows a schematic cross-sectional view of a MEMS pressure transducer package according to a further embodiment,
- Fig. 9: shows a schematic cross-sectional view of a MEMS pressure transducer package according to a further embodiment,
- Fig. 10: shows a schematic cross-sectional view of a MEMS pressure transducer package according to a further embodiment,
- Fig. 11: shows a schematic cross-sectional side view along the cutting line A-A in Figure 10,
- Fig. 12: shows a schematic cross-sectional view of a MEMS pressure transducer package according to a further embodiment,
- Fig. 13: shows a schematic cross-sectional side view along the cutting line B-B in Figure 12,
- Fig. 14: shows a schematic cross-sectional side view along the cutting line B-B in Figure 12, and
- Fig. 15: shows a schematic cross-sectional view of an environmental barrier structure being formed as a layer stack.

### DESCRIPTION OF THE FIGURES

Equal or equivalent elements or elements with equal or equivalent functionality are denoted in the following description by equal or equivalent reference numerals.

Method steps which are depicted by means of a block diagram and which are described with reference to said block diagram may also be executed in an order different from the depicted and/or described order. Furthermore, method steps concerning a particular feature of a device may be replaceable with said feature of said device, and the other way around.

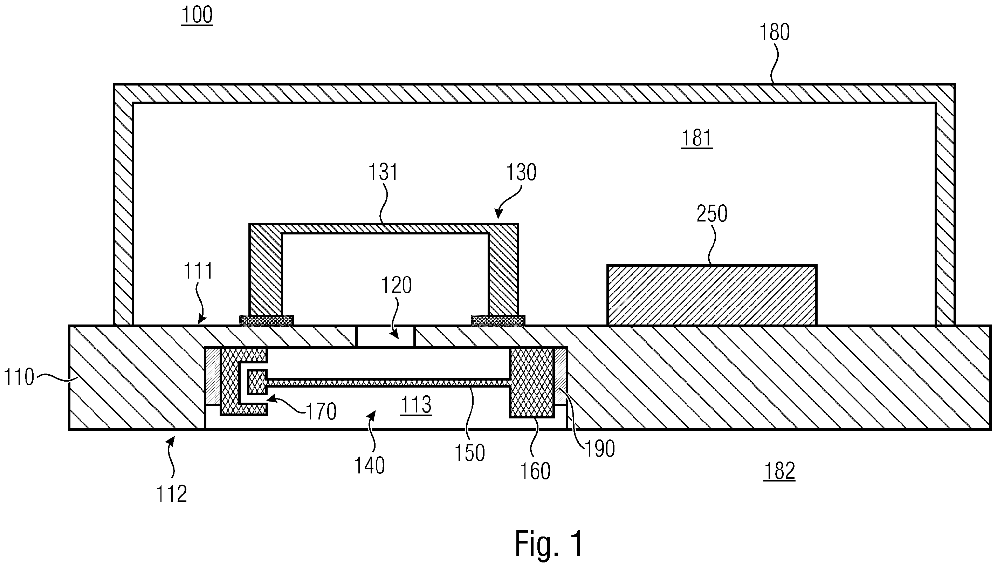

Figure 1 shows an embodiment of an innovative MEMS pressure transducer package 100. The MEMS pressure transducer package 100 comprises a substrate 110 having a through hole 120 formed therein. The through hole 120 may vertically extend between a front side of the substrate 110, e.g., a first substrate side 111, and an opposite back side of the substrate 110, e.g. an opposite second substrate side 112.

As exemplarily depicted, the substrate 110 may comprise a recess 113 provided in the second substrate side 112. Accordingly, the through hole 120 may extend between the first substrate side 111 and the recess 113. In this case, the bottom portion of the recess 113 may form the second substrate side 112.

The MEMS pressure transducer package 100 may also comprise a MEMS pressure transducer device 130. The MEMS pressure transducer device 130 may, for instance, be designed as a MEMS microphone or a MEMS pressure sensor. The MEMS pressure transducer device 130 may comprise a deflectable membrane 131. The membrane 131 may be deflected in response to air pressure, for example sound waves travelling through the through hole 120. Thus, the through hole 120 may also be referred to as a sound port. The exemplarily depicted configuration of the MEMS pressure transducer package 100 may be referred to as a bottom port configuration. This is different to top port configurations in which the sound port 120 is provided in the package lid 180.

The MEMS pressure transducer device 130 may face the first substrate side 111. Accordingly, the MEMS pressure transducer device 130 may cover the through hole 120 from the first substrate side 111. The MEMS pressure transducer package 100 may further comprise an environmental barrier structure 140 that provides environmental ingress protection. The environmental barrier structure 140 may face the second substrate side 112. Accordingly, the environmental barrier structure 140 may cover the through hole 120 from the opposite second substrate side 112.

As exemplarily depicted in Figure 1, the environmental barrier structure 140 may be arranged inside the recess 113 that may be provided in the substrate 110. Alternatively, but not explicitly shown, the substrate 110 may not comprise a recess 113. In this case, the environmental barrier structure 140 could be arranged on a recess-less plane surface on the second substrate side 112.

The outer dimensions of the environmental barrier structure 140 may be smaller than the inner dimensions of the recess 113. Thus, the environmental barrier structure 140 may be loosely fitted inside the recess 113. In order to compensate for the loose-fit play between the environmental barrier structure 140 and the recess 113, a filling material 190 can be applied between the environmental barrier structure 140 and the recess 113, thereby securing the environmental barrier structure 140 inside the recess 113.

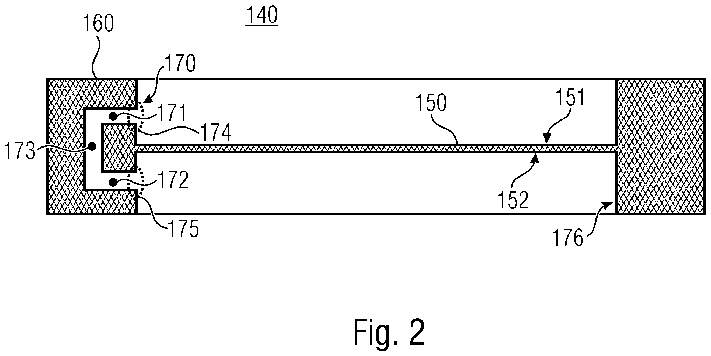

Figure 2 shows a cross-sectional side view of the innovative environmental barrier structure 140. As can be seen, the environmental barrier structure 140 may comprise a compliant membrane 150 being suspended inside a frame 160. The frame 160 may laterally surround the membrane 150, similar to a window frame laterally surrounding a window. The term 'compliant' in this regard is used in the sense of 'flexible'.

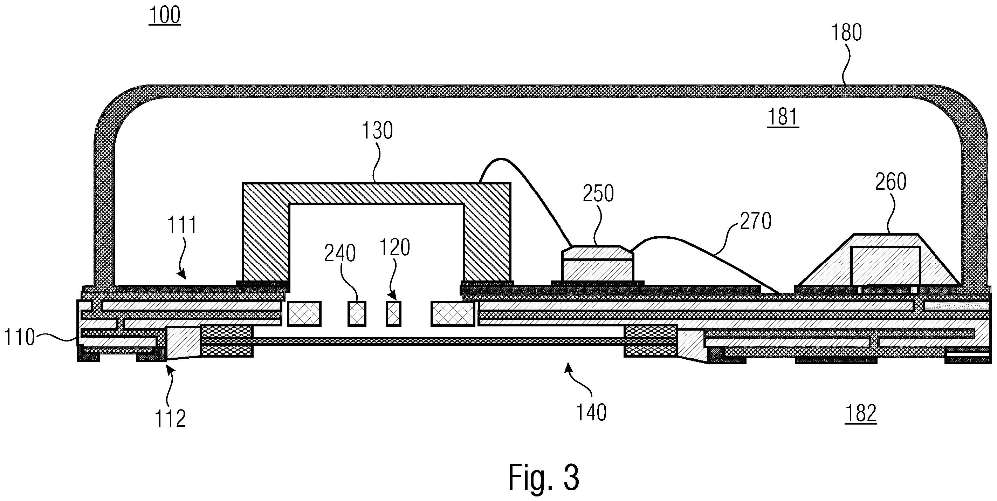

Briefly referring to Figure 3, the environmental barrier structure 140 may face the second substrate side 112. Accordingly, the environmental barrier structure 140 may cover the through hole / sound port 120 from the second substrate side 112. In this case, the substrate 110 may be sandwiched between the environmental barrier structure 140 and the MEMS pressure transducer device 130. In other words, the MEMS pressure transducer device 130 and the environmental barrier structure 140 may each be positioned on two opposite substrate sides 111, 112.

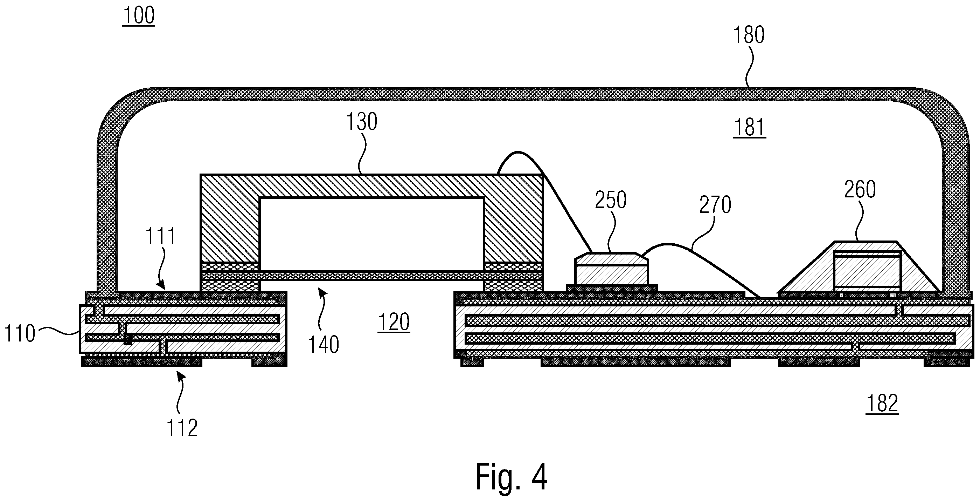

Briefly referring to Figure 4, the environmental barrier structure 140 may alternatively face the first substrate side 111. Accordingly, the environmental barrier structure 140 may cover the through hole / sound port 120 from the first substrate side 111. In this case, the environmental barrier structure 140 may be sandwiched between the substrate 110 and the MEMS pressure transducer device 130. In other words, the MEMS pressure transducer device 130 and the environmental barrier structure 140 may both be positioned on the same substrate side, e.g., on the first substrate side 111. As exemplarily depicted in Figure 4, the environmental barrier structure 140 may be directly mounted on the substrate 110, while the MEMS pressure transducer device 130, in turn, may be directly mounted on the environmental barrier structure 140.

In both cases, however, an additional ingress protection member 240, e.g., a rigid environmental barrier mesh structure, may be provided. The additional ingress protection member 240 may be arranged inside the through hole / sound port 120.

Returning to Figure 1, the MEMS pressure transducer package 100 may comprise a package lid 180 being arranged on the same side of the substrate 110 as the MEMS pressure transducer device 130, e.g., on the first substrate side 111. Thus, the package lid 180 may cover the MEMS pressure transducer device 130.

The inside of the package lid 180 defines a package interior 181, while the outside of the package lid 180 defines a package exterior 182. In other words, a space underneath the lid 180 defines the package interior 181. In case of a MEMS microphone 130, the package interior 181 may also be referred to as the back volume of the MEMS microphone 130.

In some applications, the package lid 180 may be hermetically sealed. If no ventilation is provided, then the membrane 150 may be unwantedly deflected due to environmental static pressure variations. This would lead to false signals. In order to provide a ventilation, conventional environmental barrier structures comprise porous / air permeable membranes. However, since these membranes are air permeable, they may also be permeable for small environmental particles. Thus, environmental ingress protection is decreased.

The herein disclosed innovative approach provides a solution for enhancing ingress protection, while at the same time providing sufficient ventilation. For doing so, the environmental barrier structure 140 may comprise a fluid channel 170 extending through the frame 160. In other words, a fluid channel 170 may be integrated in the frame 160. The fluid channel 170 enables a fluid communication between a first and an opposite second side 151, 152 of the membrane 150. For example, the fluid channel 170 may provide a ventilation path between the first membrane side 151 and the opposite second membrane side 152.

The fluid channel 170 may enable a fluid communication between the package interior 181 and the package exterior 182. For example, the fluid channel 170 may provide a ventilation path for enabling a pressure equalization between the package interior 181 and the package exterior 182.

This allows for providing a solid, non-porous / impermeable, membrane 150. Additionally or alternatively, the membrane 150 may be sealed such that the membrane 150 becomes leakproof. Accordingly, ingress of environmental particles or fluids, like moisture, sweat, and the like, is prevented. A sealed membrane 150 can be used in all embodiments disclosed herein.

Furthermore, as can be seen in Figure 1, the frame 160 of the environmental barrier structure 140 may be attached to the substrate 110 such that the membrane 150 is spaced apart from the through hole 120, thus, allowing the membrane 150 to freely oscillate. Accordingly, the membrane 150 may transmit sound waves from the package exterior 182 to the package interior 181. Sound wave transmission is even more enhanced in case the membrane 150 is non-porous / impermeable.

As exemplarily depicted in Figures 1, 3 and 4, further components may be arranged inside the package interior 181, for example a controller (IC, ASIC, etc.) 250 for controlling the MEMS pressure transducer device 130, and optionally additional further components 260 , such as sensors, actuators, and the like. The MEMS pressure transducer device 130, the controller 250 and any optionally available further components 260 may be electrically connected to each other by means of bond wires 270.

Alternatively, the controller 250 and any optionally available further components 260 may be arranged outside the package 110, e.g., next to the package lid 180, on the first substrate side 111. In this case, electrical connections between the MEMS pressure transducer device 130 in the package interior 181 and the controller 250 and any optionally available further components 260 in the package exterior 180 may be provided inside the substrate 110, for example by means of integrated metal layers, such as redistribution layers.

In any case, miniaturization of the MEMS package 100 is desired. Since the innovative environmental barrier structure 140 may be designed as an environmental barrier chip using conventional (semiconductor) chip manufacturing techniques, the footprint of the environmental barrier structure 140 can be made extremely small.

As exemplarily depicted in Figure 1, the footprint of the environmental barrier structure 140 may be smaller than the footprint of the package lid 180. Accordingly, when viewed from a top view onto the package lid 180, the outer circumference of the package lid 180 may encompass the outer circumference of the environmental barrier structure 140. Thus, the lateral dimensions of the environmental barrier structure 140 can be made significantly smaller than the lateral dimensions of the package lid 180. Thus, the footprint of the entire MEMS pressure transducer package 100 can be significantly reduced.

In the exemplary embodiment as shown in Figures 1 and 2, the fluid channel 170 has a U-shaped cross section having first and second channel sections 171, 172 extending in parallel to the membrane 150 and an intermediate third channel section 173 extending orthogonally to the membrane 150. The intermediate third channel section 173 connects the first and second channel sections 171, 172 with each other.

The first channel section 171 is in fluid communication with the first side 151 of the membrane 150, and the second channel section 172 is in fluid communication with the second side 152 of the membrane 150. Accordingly, the membrane 150 is positioned between the first and second channel sections 171, 172, wherein one of the first and second channel sections 171, 172 is in fluid communication with the top side 151 of the membrane 150, while the other one of the first and second channel sections 171, 172 is in fluid communication with the bottom side 152 of the membrane 150.

The first channel section 171 terminates in a first opening 174 provided in the frame 160, said first opening 174 facing an opposite side 176 of the frame 160. In other words, said first opening 174 faces the inside of the frame 160. Accordingly, the first channel section 171 emerges from a lateral side (above the membrane 150) of the frame 160.

The second channel section 172 may also emerge from a lateral side (beneath the membrane 150) of the frame 160. That is, the second channel section 172 terminates in a second opening 175 provided in the frame 160, wherein said second opening 175 also faces the opposite side 176 of the frame 160. In other words, said second opening 175 also faces the inside of the frame 160.

The membrane 150 is horizontally spanned inside the frame 160. Accordingly, the membrane 150 extends horizontally, i.e., substantially parallel to the substrate 110. Regarding the vertical (orthogonal to the substrate 110) position of the membrane 150, it can be seen that the membrane 150 is vertically positioned along the third channel section 173, i.e., vertically between the first and second channel sections 171, 172.

Though not explicitly depicted in Figure 2, the frame 160 may comprise one or more fluid channels 170 as described above. The fluid channels 170 may be arranged opposite to each other.

Accordingly, a U-shaped fluid channel 170 forming a fluid path can be provided between the two sides 151, 152 of the membrane 150, wherein the fluid path 170 is integrated in the frame 160 of the environmental barrier structure 140. As mentioned above, the fluid channel 170 may provide a ventilation path, in particular a ventilation path between the package interior 181 and the package exterior 182.

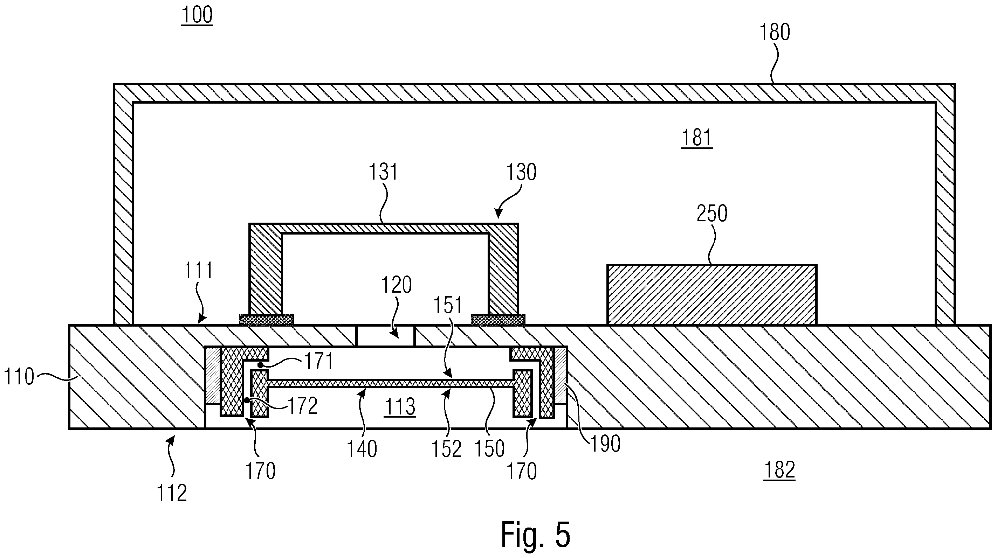

Some further exemplary embodiments of the fluid channel 170 will be explained in the following with reference to Figures 5 to 15. Components with like functionality as in other embodiments will be assigned like reference numerals, and a repeated detailed discussion is omitted for the sake of conciseness. In other words, everything that is discussed with reference to a particular feature shown in one particular embodiment also holds for the like feature with like reference numeral in each other embodiment.

Figure 5 shows a further exemplary embodiment of a MEMS pressure transducer package 100 comprising an innovative environmental barrier structure 140 having an integrated fluid channel 170 provided inside the frame 160.

In this embodiment, the fluid channel 170 has an L-shaped or inverted L-shaped cross section. The fluid channel 170 may comprise a first channel section 171 extending in parallel to the membrane 150 and being in fluid communication with the first side 151 (e.g., top side) of the membrane 150. The fluid channel 170 may comprise a second channel section 172 extending orthogonally to the membrane 150 and being in fluid communication with the second side 152 (e.g., bottom side) of the membrane 150.

The first and second channel sections 171, 172 are in fluid communication with each other so as to provide a fluid path, e.g., a ventilation path, between the first and second membrane sides 151, 152. Accordingly, the first and second channel sections 171, 172 may provide a fluid path, e.g., a ventilation path, between the package interior 181 and the package exterior 182.

The first channel section 171 terminates in a first opening provided in the frame 160, said first opening facing an opposite side of the frame 160. In other words, said first opening faces the inside of the frame 160. Accordingly, the first channel section 171 emerges from a lateral side (above the membrane 150) of the frame 160.

The second channel section 172 emerges from the bottom side (beneath the membrane 150) of the frame 160. That is, the second channel section 172 terminates in a second opening provided in the frame 160, said second opening facing away from the MEMS pressure transducer device 130 and facing towards the package exterior 182.

The membrane 150 is horizontally spanned inside the frame 160. Accordingly, the membrane 150 extends horizontally, i.e., substantially parallel to the substrate 110. Regarding the vertical (orthogonal to the substrate 110) position of the membrane 150, it can be seen that the membrane 150 is positioned vertically along the second channel section 172.

As can be seen in Figure 5, the frame 160 may comprise one or more fluid channels 170 as described above. The fluid channels 170 may be arranged opposite to each other, as exemplarily depicted in Figure 5.

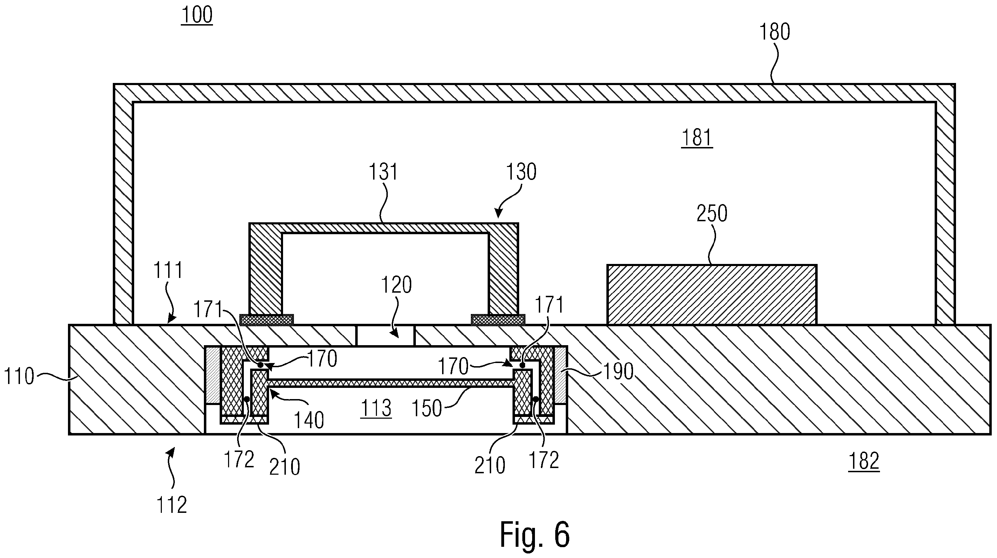

Figure 6 shows a further exemplary embodiment of a MEMS pressure transducer package 100 comprising an innovative environmental barrier structure 140 having an integrated fluid channel 170 provided inside the frame 160. This embodiment is very similar to the embodiment discussed above with reference to Figure 5. However, it differs from the embodiment of Figure 5 in that the fluid channel 170 is covered by an external ingress protection member 210 being attached to the frame 160.

The external ingress protection member 210 may cover the fluid channel 170, and in particular the above described second channel section 172. The external ingress protection member 210 may comprise, or be provided as, a mesh structure, for example, a rigid mesh.

Additionally or alternatively, an external ingress protection member 210 may be attached to the frame 160 so as to cover the above described first channel section 171.

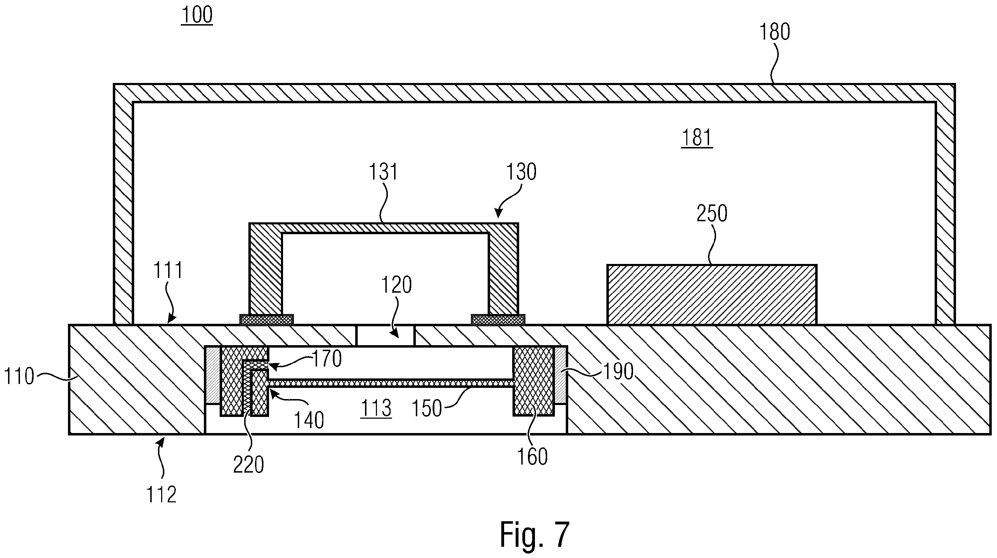

Figure 7 shows a further exemplary embodiment of a MEMS pressure transducer package 100 comprising an innovative environmental barrier structure 140 having an integrated fluid channel 170 provided inside the frame 160. This embodiment is very similar to the embodiment discussed above with reference to Figure 5. However, it differs from the embodiment of Figure 5 in that the fluid channel 170 comprises an internal ingress protection member 220 being arranged inside the fluid channel 170.

Internal ingress protection members 220 and external ingress protection members 210 (Fig. 6) may be combined with each other.

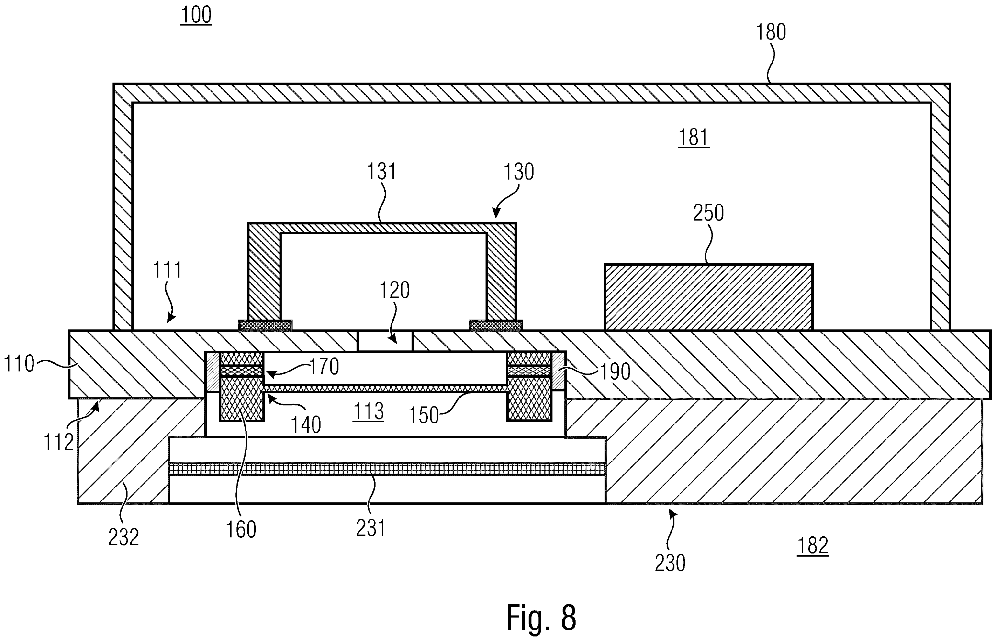

Figure 8 shows a further exemplary embodiment of a MEMS pressure transducer package 100 comprising an innovative environmental barrier structure 140 having an integrated fluid channel 170 provided inside the frame 160.

In this embodiment, the MEMS pressure transducer package 100 comprises an external ingress protection member 230 being attached to the substrate 110 on the second substrate side 112, such that the environmental barrier structure 140 is arranged between the MEMS pressure transducer 130 and the external ingress protection member 230.

The external ingress protection member 230 may comprise an ingress protection substrate 232 comprising a grid or mesh structure 231. For example, the ingress protection substrate 232 may comprise a recess inside of which a grid or mesh structure 231 is arranged. The ingress protection substrate 232 may be attached to the second substrate side 112 of the package substrate 110. The grid or mesh structure 231 may cover the environmental barrier structure 140 being arranged inside the recess 113 provided in the package substrate 110.

The external ingress protection member 230 of Figure 8 may be combined with at least one of the internal ingress protection member 220 as discussed with reference to Figure 7 and the external ingress protection member 210 as discussed with reference to Figure 6. Furthermore, the internal and external ingress protection members 210, 220, 230 as discussed with reference to Figures 6, 7 and 8 may be employed in each embodiment discussed herein.

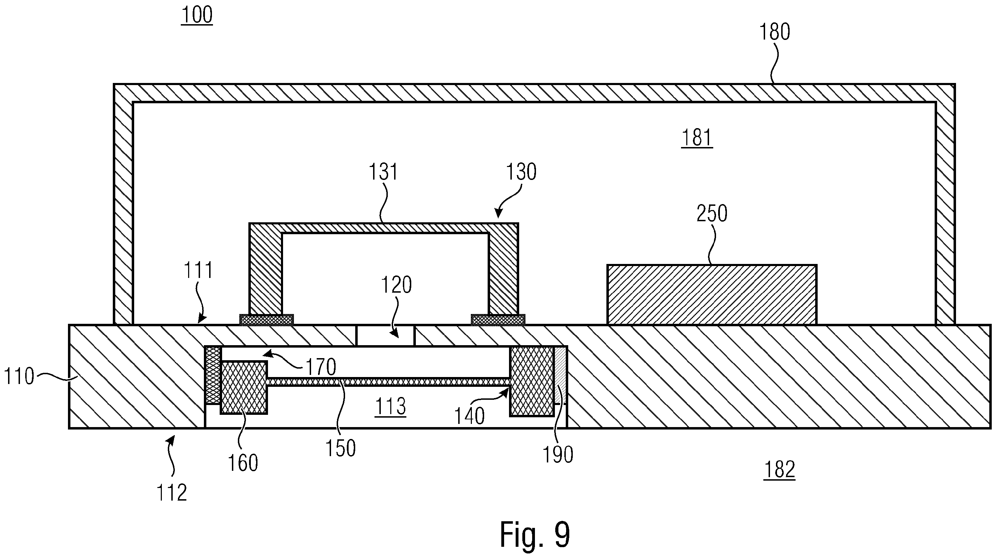

Figure 9 shows a further exemplary embodiment of a MEMS pressure transducer package 100 comprising an innovative environmental barrier structure 140 having an integrated fluid channel 170 provided inside the frame 160.

In this embodiment, the fluid channel 170 has a straight cross section extending in parallel to the membrane 150. The fluid channel 170 may be provided in a portion of the frame 160 that is positioned between the membrane 150 and the substrate 110, such that the fluid channel 170 linearly extends between the membrane 150 and the substrate 110.

The fluid channel 170 is arranged directly adjacent to the substrate 110, such that fluid flowing through the fluid channel 170 comes into direct contact with the frame 160 and with the substrate 110.

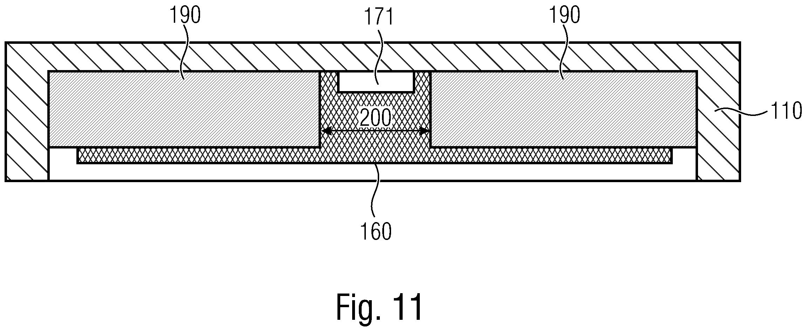

It is to be noted that Figure 9 shows a cross-sectional view. Accordingly, the fluid channel 170 may be laterally surrounded by frame material, as will be explained in more detail with reference to Figure 11. However, said surrounding frame material may not be visible in the cross-sectional view of Figure 9.

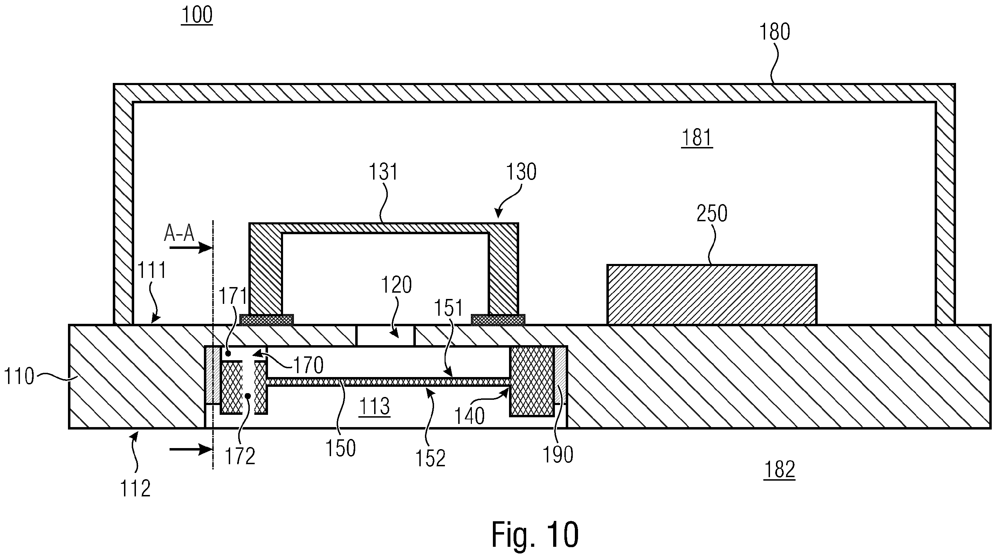

Figure 10 shows a further exemplary embodiment of a M EMS pressure transducer package 100 comprising an innovative environmental barrier structure 140 having an integrated fluid channel 170 provided inside the frame 160.

This embodiment is similar to the embodiment of Figure 9. However, it may differ from the embodiment of Figure 9 in that the fluid channel 170 comprises a T-shaped cross section.

In particular, the fluid channel 170 may comprise a first channel section 171 extending in parallel to the membrane 150 and being in fluid communication with the first side 151 (top side) of the membrane 150. The fluid channel 170 may further comprise a second channel section 172 extending orthogonally to the membrane 150 and being in fluid communication with the second side 152 (bottom side) of the membrane 150.

The first and second channel sections 171, 172 are in fluid communication with each other, so as to provide a fluid path, e.g., a ventilation path, between the first and second membrane sides 151, 152. Accordingly, the first and second channel sections 171, 172 may provide a fluid path, e.g., a ventilation path, between the package interior 181 and the package exterior 182. The first channel section 171 is arranged directly adjacent to the substrate 110, such that fluid flowing through the first channel section 171 comes into direct contact with the frame 160 and with the substrate 110.

The first channel section 171 extends horizontally, i.e., parallel to the membrane 150, through the frame 160. The first channel section 171 may extend completely through the frame 160 such that it terminates in a first opening facing towards the inside of the frame 160, as well as in an opposite second opening facing towards the outside of the frame 160.

The second channel section 172 emerges from the bottom side (beneath the membrane 150) of the frame 160. That is, the second channel section 172 terminates in a third opening provided in the frame 160, said third opening facing away from the MEMS pressure transducer device 130 and facing towards the package exterior 182.

The membrane 150 is horizontally spanned inside the frame 160. Accordingly, the membrane 150 extends horizontally, i.e., substantially parallel to the substrate 110. Regarding the vertical (orthogonal to the substrate 110) position of the membrane 150, it can be seen that the membrane 150 is positioned vertically along the second channel section 172.

Though not explicitly shown in Figure 10, the frame 160 may comprise one or more fluid channels 170 as described above. The fluid channels 170 may be arranged opposite to each other, similar to the embodiment as depicted in Figure 5.

Figure 11 shows a cross-sectional view of the environmental barrier structure 140, cut along the line A-A in Figure 10. As can be seen, the first channel section 171 of the fluid channel 170 is arranged directly adjacent to the substrate 110, such that fluid flowing through the first channel section 171 comes into direct contact with the frame 160 and with the substrate 110.

Furthermore, as mentioned above with reference to Figure 9, here one can see that the fluid channel 170 may be laterally surrounded by frame material, which was not visible in the cross-sectional view of Figure 9.

As can be seen in Figure 11, however, the filling material 190 is intermittently applied resulting in a gap 200 without any filling material 190, wherein the fluid channel 170 is arranged in said gap 200 thereby leaving the fluid channel 170, and in particular the first channel section 171, uncovered. Thus, environmental air may flow through the gap 200 and through the fluid channel 170 between the package interior 181 and the package exterior 182.

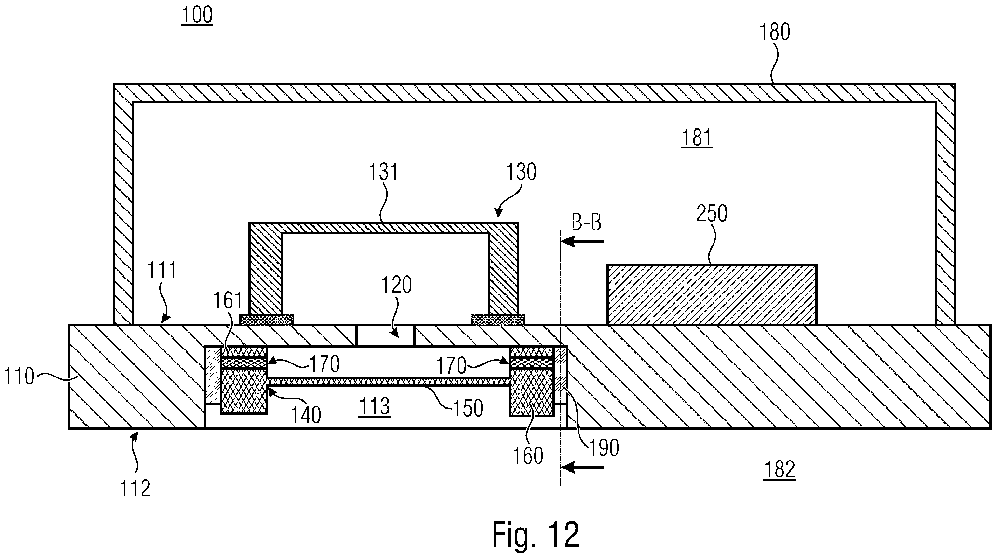

Figure 12 shows a further exemplary embodiment of a MEMS pressure transducer package 100 comprising an innovative environmental barrier structure 140 having an integrated fluid channel 170 provided inside the frame 160.

This embodiment is similar to the embodiment of Figure 9. However, it may differ from the embodiment of Figure 9 in that frame material 161 (i.e., an upper frame portion) is arranged between the substrate 110 and the fluid channel 170. Accordingly, fluid flowing through the fluid channel 170 is not in direct contact with the substrate 110.

The filling material 190 may be porous / permeable for allowing fluid to pass through the filling material 190 and to reach the fluid channel 170. Thus, the filling material 190 may be applied completely surrounding the frame 160 resulting in an enhanced stability when attaching the frame 160 to the substrate 110.

The fluid channel 170 may comprise a small channel width that may only partially extend along the width of the frame 160. Alternatively, the fluid channel 170 may comprise a large channel width that may extend along the entire width of the frame 160.

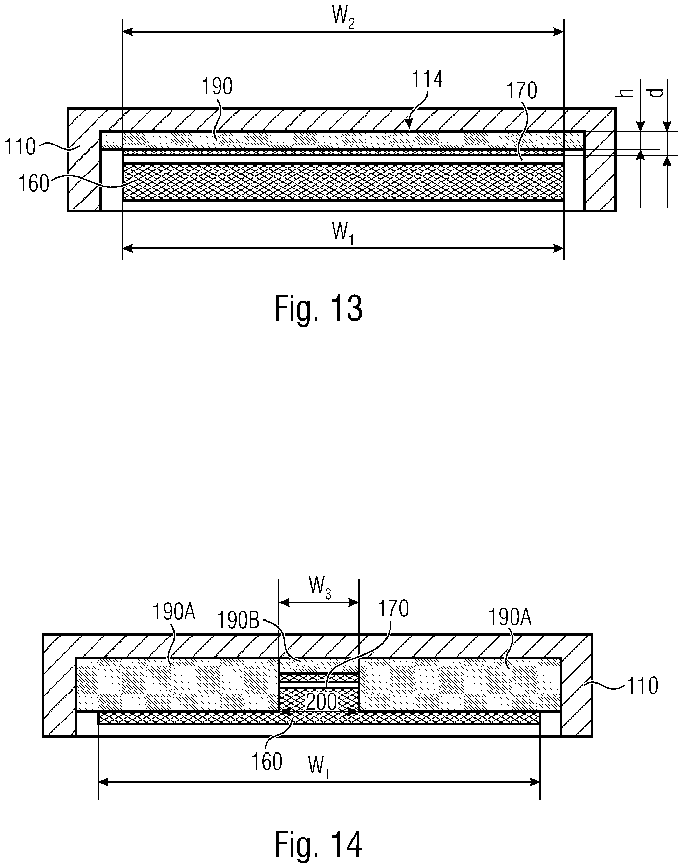

This shall be briefly explained with reference to Figures 13 and 14 which show a cross-sectional view along the cutting line B-B in Figure 12. The frame 160 may comprise a width W₁ being measured parallel to the membrane 150. As can be seen in Figure 13, the fluid channel 170 may comprise a large channel width W₂ that may extend along the entire width W₁ of the frame 160.

Figure 14 may show a further embodiment, wherein the fluid channel 170 may comprise a small channel width W₃ that may only partially extend along the width W₁ of the frame 160. Alternatively, the fluid channel 170 of Figure 14 may comprise a large channel width W₃ that may extend along the entire width W₁ of the frame 160, even though it is not visible here since the fluid channel 170 may partially covered by filling material 190.

Furthermore, Figures 13 and 14 shows some exemplary embodiments of applying a filling material 190 in case it is not porous / permeable as discussed above with reference to Figure 12, in order to provide access to the fluid channel 170. However, the filling material 190 of Figures 13 and 14 may also be porous / permeable.

The filling material 190 may be applied directly onto the substrate 110. In particular, the filling material 190 may be applied onto a surface 114 of the substrate 110 residing inside the recess 113, which surface 114 corresponds to the bottom of the recess 113. In other words, the filling material 190 may be applied onto a surface 114 of the substrate 110 that resides inside the recess 113 and that is opposite to the first substrate surface 111. For example, the filling material 190 may be applied in the form of a thin layer thereby leaving the fluid channel 170 uncovered.

As shown in Figure 13, a distance *d*, measured orthogonally to the membrane 150, between the fluid channel 170 and the above mentioned substrate surface 114 may be larger than a height *h* of the filling material 190 being applied onto said substrate surface 114. Accordingly, the filling material 190 is positioned closer to the substrate surface 114 than the fluid channel 170 is, thereby leaving the fluid channel 170 uncovered from filling material 190. In other words, the filling material 190 may be applied along the perimeter of the frame 160 of the environmental barrier structure 140 with leaving the fluid channel 170 uncovered.

Figure 14 shows an alternative, wherein the filling material 190 is applied along the perimeter of the environmental barrier structure 140 with partially covering the fluid channel (170). As can be seen, the filling material 190 may comprise thick portions 190A that may cover the fluid channel 170. These thick portions 190A may comprise a gap 200, wherein the fluid channel 170 may be arranged in said gap 200 thereby leaving the fluid channel 170 uncovered within the gap 200. Thin portions 190B of filling material 190 may be provided in said gap 200, which thin portions 190B correspond to the thin layer discussed above with reference to Figure 13. Thus, the gap 200 may provide access to the fluid channel 170.

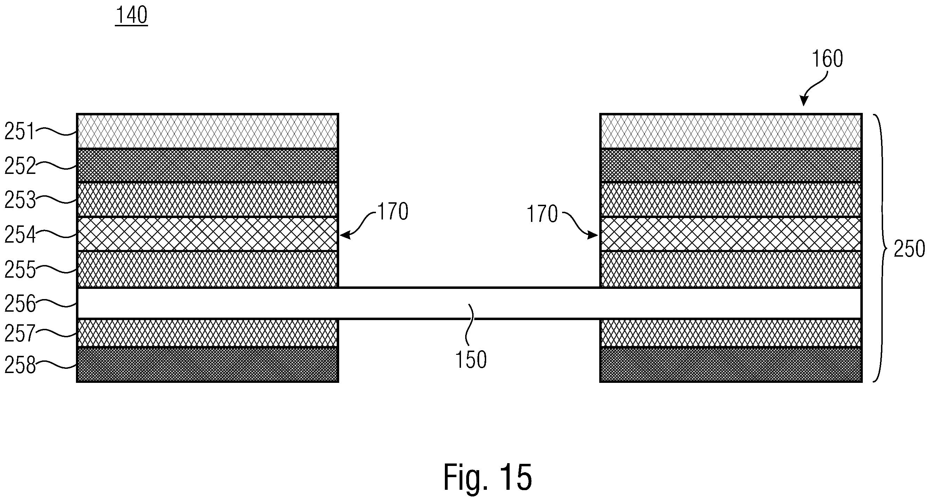

Figure 15 shows a schematic cross-sectional view of an environmental barrier structure 140 comprising a frame 160 and a membrane 150 spanned horizontally inside said frame 160, wherein the frame 160 comprises one or more integrated fluid channels 170, as discussed above.

For example, the environmental barrier structure 140 may be manufactured by using conventional (semiconductor) MEMS fabrication techniques. The environmental barrier structure 140 may comprise a plurality of stacked layers 251, ..., 258 from same or different materials. Accordingly, the environmental barrier structure 140 may be configured as a layer stack 250. For example, several layers 251, ... , 258 may be stacked one atop the other.

As a non-limiting example, the layer stack 250 may comprise one or more layers 251, ..., 258 of the group comprising polyimide and HAF (Heat Activated Films). For example, layers 251, 253, 255 and 257 may be HAF layers, while layers 252 and 258 may be polyimide layers.

The layer stack 250 as exemplarily depicted in Figure 15 may be created by laminating the different layers 251, ..., 258 and curing the HAF layers 251, 253, 255, 257 so as to firmly bond the layers 251, ..., 258 with each other. For example, the structures may then be punched into the cured layer stack 250 resulting in the above discussed frame 160 inside of which a membrane 150 is suspended.

Layer 256, which forms the membrane 150, may comprise at least one of ePTFE (expanded polytetrafluoroethylene), polyurethane, PPE (polyphenyl ethers), PI (polyimide) or silicon. The membrane 150 may additionally be sealed so as to be impermeable for fluids.

At least one of the several layers 251, ..., 258 in the layer stack 250 may have a permeable characteristic. For instance, layer 254 may be permeable for fluids like air, gases, etc. The permeable layer 254 may form the above discussed fluid channel 170. Additionally or alternatively, a physical channel structure may be created inside the layer stack 250, e.g., by drilling, etching and the like, which then forms the fluid channel 170. The fluid channel 170 may comprise one or more of the above discussed internal and/or external ingress protection members 210, 220, 230.

Layer 254, which forms the fluid channel 170, may comprise at least one of a metal mesh, a glass fiber mesh, a phase inversion membrane or an electrospun membrane that may, for instance, be manufactured by electrospinning.

Summarizing, the present innovative concept provides a MEMS pressure transducer package 100 with one or more MEMS devices, such as a MEMS pressure transducer device 130, being covered by a lid 180. An opening 120, e.g., a sound port, may be provided underneath the MEMS device 130 for allowing fluid, like air, entering the package interior 181 through the sound port 120. An environmental barrier structure 140 may cover the opening 120 in order to provide a mechanical protection from environmental ingress. The environmental barrier structure 140 comprises a frame 160 carrying a membrane 150.

According to the present innovative concept, a fluid channel 170 may be integrated inside said frame 160. The fluid channel 170 provides a fluid communication between a first side 151 and an opposite second side 152 of the membrane 150 and, thus, a fluid communication between a package interior 181 and a package exterior 182. This allows to provide a ventilation for compensating static pressure deviations. At the same time, the membrane 150 may be impermeable for fluids, e.g., by being sealed and/or coated, allowing an excellent acoustic sound transmission. Moreover, the coated / sealed membrane 150 may provide an excellent protection from environmental ingress, such as dust particles, water droplets, sweat, etc. Yet further, the coated / sealed membrane 150 may provide protection from immersion, e.g., waterproofness.

This becomes possible because the integrated fluid channel 170 provides a separate ventilation path being separated from the membrane 150, i.e., the membrane 150 itself does not need to be porous / permeable anymore. Therefore, the innovative concept allows to combine all desired features of an environmental barrier structure 140 that were mutually exclusive before, such as:
• protecting the microphone from dust particles,
• protecting the microphone from water droplets and immersion,
• allowing for a ventilation and hence a compensation of static pressures, and
• providing acoustic sound transmission.

Accordingly, the innovative approach allows for higher material selection flexibility for the membrane material thereby enhancing compliance and ventilation of the environmental barrier structure 140. According to the innovative concept, the ventilation path 170 is separated from the membrane 150. This can be achieved by integrating a specific ventilation path 170 inside the frame 160 of the environmental barrier structure 140. Thus, the membrane 150 itself can be sealed to become impermeable and without the need of porous or extruded structures. In addition, this might also be helpful for the ingress protection performance. Furthermore, such an environmental barrier structure 140 can serve as a one to one replacement for current ePTFE based environmental barrier approaches, without the need of major changes in the package concept or package production flow. This might be particularly interesting for the future since, due to upcoming restrictions on the usage of PFAS based material, ePTFE membranes will have to be replaced.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

While this disclosure has been described with reference to illustrative embodiments, this description is not intended to be construed in a limiting sense. Various modifications and combinations of the illustrative embodiments, as well as other embodiments of this disclosure, will be apparent to persons skilled in the art upon reference to the description. It is therefore intended that the appended claims encompass any such modifications or embodiments.

## Claims

1. A MEMS pressure transducer package (100) comprising
a substrate (110) comprising a through hole (120),
a MEMS pressure transducer device (130) covering the through hole (120) from a first substrate side (111), and
an environmental barrier structure (140) covering the through hole (120) from the first or an opposite second substrate side (111, 112),
the environmental barrier structure (140) comprising:
a compliant membrane (150) being suspended inside a frame (160), and
a fluid channel (170) extending through the frame (160),
wherein the fluid channel (170) provides a fluid communication between a first and an opposite second side (151, 152) of the membrane (150).

2. The MEMS pressure transducer package (100) according to claim 1,
further comprising a package lid (180) being arranged on the first substrate side (111) and covering the MEMS pressure transducer device (130),
wherein the inside of the package lid (180) defines a package interior (181), and
wherein the fluid channel (170) provides a fluid communication between the package interior (181) and a package exterior (182).

3. The MEMS pressure transducer package (100) according to claim 2,
wherein the package lid (180) is hermetically sealed, and
wherein the fluid channel (170) provides a ventilation path for enabling a pressure equalization between the package interior (181) and the package exterior (182).

4. The MEMS pressure transducer package (100) according to claim 2 or 3,
wherein the footprint of the environmental barrier structure (140) is smaller than the footprint of the package lid (180), and
wherein, when viewed from a top view onto the package lid (180), the outer circumference of the package lid (180) encompasses the outer circumference of the environmental barrier structure (140).

5. The MEMS pressure transducer package (100) according to any one of the preceding claims,
wherein the frame (160) is attached to the substrate (110) such that the membrane (150) is spaced apart from the through hole (120), allowing the membrane (150) to freely oscillate.

6. The MEMS pressure transducer package (100) according to any one of the preceding claims,
wherein the membrane (150) is a solid, non-porous, membrane, and/or wherein the membrane (150) is sealed.

7. The MEMS pressure transducer package (100) according to any one of the preceding claims,
wherein the fluid channel (170) has a U-shaped cross section having first and second channel sections (171, 172) extending in parallel to the membrane (150) and an intermediate third channel section (173) extending orthogonally to the membrane (150),
the intermediate third channel section (173) connecting the first and second channel sections (171, 172) with each other,
wherein the first channel section (171) is in fluid communication with the first side (151) of the membrane (150), and wherein the second channel section (172) is in fluid communication with the second side (152) of the membrane (150),
wherein the membrane (150) is positioned between the first and second channel sections (171, 172).

8. The MEMS pressure transducer package (100) according to any one of claims 1 to 6,
wherein the fluid channel (170) has an L-shaped cross section having
a first channel section (171) extending in parallel to the membrane (150) and being in fluid communication with the first side (151) of the membrane, and
a second channel section (172) extending orthogonally to the membrane (150) and being in fluid communication with the second side (152) of the membrane (150),
the first and second channel sections (171, 172) being in fluid communication with each other, and
wherein the membrane (150) is positioned along the second channel section (172).

9. The MEMS pressure transducer package (100) according to any one claims 1 to 6,
wherein the fluid channel (170) has a T-shaped cross section having
a first channel section (171) extending in parallel to the membrane (150) and being in fluid communication with the first side (151) of the membrane (150), and
a second channel section (172) extending orthogonally to the membrane (150) and being in fluid communication with the second side (152) of the membrane (150),
the first and second channel sections (171, 172) being in fluid communication with each other,
wherein the first channel section (171) is arranged directly adjacent to the substrate (110), such that fluid flowing through the first channel section (171) comes into contact with the frame (160) and with the substrate (110), and
wherein the membrane (150) is positioned along the second channel section (172).

10. The MEMS pressure transducer package (100) according to any one of claims 1 to 6,
wherein the fluid channel (170) has a straight cross section extending in parallel to the membrane (150), and
wherein the fluid channel (170) is provided in a portion of the frame (160) that is positioned between the membrane (150) and the substrate (110), such that the fluid channel (170) linearly extends between the membrane (150) and the substrate (110).

11. The MEMS pressure transducer package (100) according to claim 10,
wherein frame material (161) is arranged between the substrate (110) and the fluid channel (170), or
wherein the fluid channel (170) is arranged directly adjacent to the substrate (110), such that fluid flowing through the fluid channel (170) comes into contact with the frame (160) and with the substrate (110).

12. The MEMS pressure transducer package (100) according to any one of the preceding claims,
wherein the substrate (110) comprises a recess (113) provided in the second substrate side (112), wherein the environmental barrier structure (140) is arranged inside said recess (113).

13. The MEMS pressure transducer package (100) according to claim 12,
wherein the outer dimensions of the environmental barrier structure (140) are smaller than the inner dimensions of the recess (113), such that the environmental barrier structure (140) is loosely fitted inside the recess (113), and
wherein a filling material (190) is applied between the environmental barrier structure (140) and the recess (113) for securing the environmental barrier structure (140) inside the recess (113).

14. The MEMS pressure transducer package (100) according to claim 13,
wherein the filling material (190) is applied along the perimeter of the environmental barrier structure (140) with partially covering the fluid channel (170).

15. The MEMS pressure transducer package (100) according to claim 13,
wherein the filling material (190) is applied along the perimeter of the environmental barrier structure (140) with leaving the fluid channel (170) uncovered.

16. The MEMS pressure transducer package (100) according to claim 15,
wherein the filling material (190) is intermittently applied resulting in a gap (200) without any filling material (190), wherein the fluid channel (170) is arranged in said gap (200) thereby leaving the fluid channel (170) uncovered.

17. The MEMS pressure transducer package (100) according to claim 15,
wherein a distance, measured orthogonally to the membrane (150), between the fluid channel (170) and the substrate (110) is larger than a height of the filling material (190), such that the filling material (190) is positioned closer to the substrate (110) than the fluid channel (170) thereby leaving the fluid channel (170) uncovered.

18. The MEMS pressure transducer package (170) according to any one of claims 13 to 17,
wherein the filling material (190) is porous for allowing fluid to pass through the filling material (190) and to reach the fluid channel (170).

19. The MEMS pressure transducer package (100) according to any one of the preceding claims,
wherein the fluid channel (170) is covered by an external ingress protection member (210) being attached to the frame (160).

20. The MEMS pressure transducer package (100) according to any one of the preceding claims,
wherein the fluid channel (170) comprises an internal ingress protection member (220) being arranged inside the fluid channel (170).

21. The MEMS pressure transducer package (100) according to any one of the preceding claims,
further comprising an external ingress protection member (230) being attached to the substrate (110) on the second substrate side (112), such that the environmental barrier structure (140) is arranged between the MEMS pressure transducer (130) and the external ingress protection member (230).
